(19) Europäisches Patentamt
European Patent Office
Office européen des brevets

(11) **EP 2 471 178 B1**

(12) **EUROPÄISCHE PATENTSCHRIFT**

(45) Veröffentlichungstag und Bekanntmachung des Hinweises auf die Patenterteilung:
**09.01.2019 Patentblatt 2019/02**

(21) Anmeldenummer: **10745165.0**

(22) Anmeldetag: **12.08.2010**

(51) Int Cl.:
***H03H 17/00*** *(2006.01)*

(86) Internationale Anmeldenummer:
**PCT/EP2010/004926**

(87) Internationale Veröffentlichungsnummer:
**WO 2011/023299 (03.03.2011 Gazette 2011/09)**

(54) **VERFAHREN ZUR VERARBEITUNG EINES ANALOG BESTIMMTEN MESSWERTSIGNALS, RESOLVERANORDNUNG ZUR DURCHFÜHRUNG DES VERFAHRENS UND VERFAHREN ZUR BESTIMMUNG EINES AUSGANGSSTROMES EINES UMRICHTERS**

METHOD FOR PROCESSING A MEASUREMENT SIGNAL ANALOG DETERMINED,RESOLVERAPPARATUS FOR EXECUTING THE METHOD AND METHOD FOR DETERMINING AN OUTPUT CURRENT OF A RECTIFIER

PROCÉDÉ DE TRAITEMENT D'UN SIGNAL DE VALEUR DE MESURE DÉTERMINÉ ANALOGIQUEMENT, DISPOSITIF RÉSOLVEUR PERMETTANT DE METTRE EN OEUVRE LE PROCÉDÉ ET PROCÉDÉ DE DÉTERMINATION D'UN COURANT DE SORTIE D'UN CONVERTISSEUR

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **26.08.2009 DE 102009038594**
**16.07.2010 DE 102010027471**

(43) Veröffentlichungstag der Anmeldung:
**04.07.2012 Patentblatt 2012/27**

(73) Patentinhaber: **SEW-Eurodrive GmbH & Co**
**D-76646 Bruchsal (DE)**

(72) Erfinder:
• **HAMMEL, Wolfgang**
**76646 Bruchsal (DE)**
• **NEUMAYER, Ulrich**
**76694 Forst (DE)**

(74) Vertreter: **Tüngler, Eberhard et al**
**Sew-Eurodrive**
**Ernst-Blickle-Straße 42**
**76646 Bruchsal (DE)**

(56) Entgegenhaltungen:
**EP-A1- 0 320 517     EP-A1- 1 441 440**
**DE-A1-102005 005 024     US-A- 5 249 578**
**US-A- 5 373 460     US-B1- 6 311 201**

**Beschreibung**

Die Erfindung betrifft ein Verfahren zur Verarbeitung eines analog bestimmten Messwertsignals, eine Resolveranordnung zur Durchführung des Verfahrens und Verfahren zur Bestimmung eines Ausgangsstromes eines Umrichters.

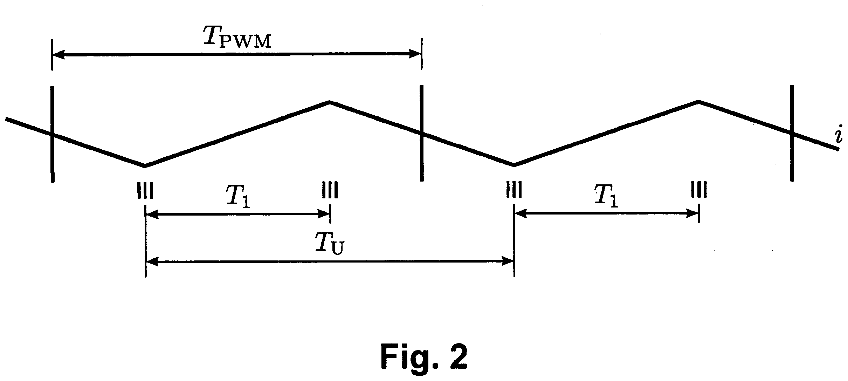

Aus der DE 10 2005 005 024 B4 ist ein Verfahren bekannt, bei dem die von einem als Winkelsensor eingesetzten Resolver erzeugten analogen Trägerspannungs-Signalwerte, deren Verlauf im Wesentlichen sinusförmig ist und deren Amplitude dem Sinuswert beziehungsweise dem Kosinuswert des zu erfassenden Winkelwertes entsprechen, in einen digitalen Datenstrom gewandelt werden. Zu dieser Analog-Digital-Wandlung wird ein Delta-Sigma-Modulator eingesetzt, dem ein Sinc$^3$-Filter nachgeschaltet ist, das als Tiefpassfilter wirkt. Denn die drei integrierend wirkenden Akkumulatoren der dortigen Figur 5 werden mit einer schnelleren Taktfrequenz $F_S$ als die drei mit der langsameren Taktfrequenz $F_D$ betriebenen Differentiatoren betrieben. Am Filter tritt ausgangsseitig ein Mehrbit-Datenstrom aus, der gemäß dortiger Figur 2 einem Dezimierungsfilter OSR2 zugeführt wird, das im Wesentlichen einer Summation, also Mittelwertbildung entspricht. An dessen Ausgang steht somit der Messwert in digitaler Form bereit.

Eine Synchronisierung des Mehrbit-Datenstroms auf sonstige Signalverläufe hin ist nur schwer oder gar nicht möglich. Die Messdauer bzw. Beginn und Ende des Messintervalls ist nur mit langen Zeitdauer $T_D$ einstellbar, da das Signal am Ausgang des dritten Integrierers mit $f_D$ unterabgetastet wird. Somit stehen ab dieser Stelle in der Signalkette sämtliche Signale nur mit der groben zeitlichen Quantisierung $T_D$ zur Verfügung. Die Festlegung des Beginns bzw. Endes oder der Messdauer über die das Dezimierungsfilter OSR2 misst kann daher nur in ganzen Vielfachen von $T_D$ erfolgen. In industriellen Anwendungen besteht jedoch häufig die Notwendigkeit, unterlagerte Regelkreise auf überlagerte Regelkreise zu synchronisieren. Diese unterschiedlichen Regelkreise können auch räumlich getrennt realisiert werden, wobei dann die zeitliche Referenzierung über ein Feldbus-System übertragen wird. Somit besteht die Aufgabe, den unterlagerten Regelkreis auf einen von außen vorgegebenen Takt zu synchronisieren. Hierzu wird üblicherweise die Periodendauer des Abtastintervalls der unterlagerten Regelkreise geringfügig verändert, um diese Synchronisation zu erreichen. Um die Synchronisierung mit hoher Qualität durchführen zu können, ist es notwendig, die Periodendauer des unterlagerten Regelkreises in möglichst kleinen Schritten verändern zu können. Eine zeitlich grobe Quantisierung der kleinsten möglichen Periodendauer-Modifikation schränkt die erreichbare Qualität der Synchronisierungsregelung somit ein. Da innerhalb einer Regelschleife auch die MesswertErfassung synchronisiert betrieben wird, führt eine grobe Quantisierung der Messzeitpunkte bzw. der Messdauer ebenfalls zu einer Einschränkung bei der Synchronisations-Regelung.

Die zugrundeliegende Aufgabe der vorliegenden Erfindung besteht also darin, ein Messverfahren anzugeben, bei dem die Festlegung des Beginns und Endes des Messintervalls bzw. der Messdauer mit einer hohen zeitlichen Auflösung möglich ist. Bei dem erfindungsgemäßen Verfahren beträgt diese zeitliche Quantisierung $T_S$, welche bei der DE 10 2005 005 024 B4 $T_D$ beträgt. Um eine ausreichende Filterwirkung des Tiefpassfilters zu erzielen ist jedoch $T_D$ wesentlich größer als $T_S$ zu wählen, wodurch sich die genannten Einschränkungen im beschriebenen Stand der Technik ergeben.

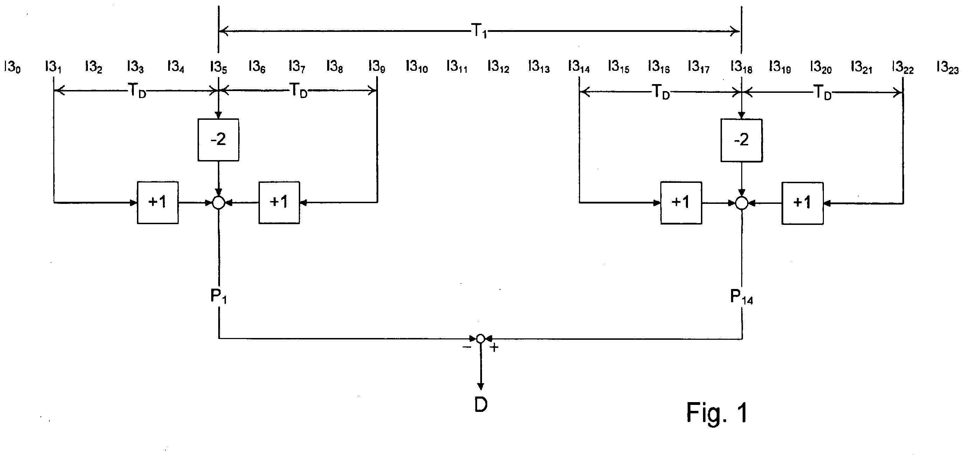

**Aus der** EP 0 320 517 B1 **ist ein digitales Dezimationsfilter bekannt, bei dem ein letzter Differenzierer k Verzögerungsglieder aufweist, welche um die Periodendauer des Ausgangsdatentaktes, also Dezimationstakt dt, verzögern. Somit sind also nur ganzzahlige Vielfache des Dezimationstakts dt als dortige Verzögerung realisierbar. Allerdings wird der letzte der Integrierer in der Figur 1 der** EP 0 320 517 B1 **gemäß dortigem Anspruch 1 mit Rücksetzeinrichtung ausgestattet, der somit wie ein Differenzierer wirkt (** EP 0 320 517 B1, **Anspruch 1, Zeile 56).**

**Aus der Figur 1 der** US 5,249,578 A **ist bekannt, einen Datenstrom einem digitalen FIR filter zuzuführen.**

**Aus der** US 5,373,460 A **ist eine gleitende Fenster-Transformation bekannt.**

**Aus der** US 6,311,201 B1 **ist als nächstliegender Stand der Technik ein Filter bekannt.**

Der Erfindung liegt die Aufgabe zugrunde, die Analog-Digital-Wandelung bei einer Messwerterfassung weiterzubilden. Insbesondere soll ermöglicht werden, Beginn und Ende des Messintervalls mit hoher zeitlicher Auflösung festzulegen.

Erfindungsgemäß wird die Aufgabe bei dem Verfahren nach den in Anspruch 1 und bei der Resolveranordnung nach Anspruch 9 angegebenen Merkmalen gelöst.

**Dabei wird das Ausgangssignal des ersten digitalen Filters dem zweiten digitalen Filter direkt, also verlustfrei und/oder vollumfänglich, zugeführt.**

Der Signaltakt $T_U$ am Ausgang des zweiten digitalen Filters ist je nach Anwendungs- und Ausführungsbeispiel des Verfahrens verschieden wählbar. Beispielsweise ist als Signaltakt $T_U$ hierbei T1, $T_D$ oder auch $T_S$ oder jedes andere ganzzahlige Vielfache von $T_S$ verwendbar. Vorteilhaft ist hierbei, dass $T_U$ als Vielfaches von TS gewählt werden kann und daher mit hoher zeitlicher Auflösung einstellbar ist.

Beispielsweise ist die Erfindung bei einer Ausführungsform anwendbar, in der das erfindungsgemäße Verfahren zur Erfassung des Ausgangsstroms "i" eines Umrichters, der pulsweitenmoduliert betrieben wird, verwendet wird. Die Messdauer T1 soll sich hierbei beispielsweise über eine halbe PWM-Periodendauer erstrecken. Damit kann T1 mit der hohen zeitlichen Auflösung von $T_S$ entsprechend der gewünschten Messdauer sehr genau eingestellt werden. Des weiteren soll in jeder PWM-Periode eine Messung erfolgen, somit wird $T_U$ unabhängig von T1 entsprechend der PWM-Periodendauer $T_{PWM}$ festgelegt. Dies kann ebenfalls mit der hohen zeitlichen Auflösung von $T_S$ geschehen. Auch wenn z.B. $T_{PWM}$ kein ganzzahliges Vielfaches von $T_S$ ist, bleibt die zeitliche Abweichung hiervon bei der Festlegung von $T_U$ durch Verwendung des erfindungsgemäßen Verfahrens sehr gering.

Von Vorteil ist dabei, dass eine verbesserte Analog-Digital-Wandlung ausführbar ist, bei der nun ein digitales Filter einsetzbar ist, das einerseits eine Tiefpassfunktion aufweist und andererseits den Datenstrom derart zur Verfügung stellt, dass die digitale Information bezüglich des Signalspannungswertes am Eingang des Delta-Sigma-Modulators mit sehr hoher Genauigkeit zur Verfügung steht. Besonders vorteilhaft ist dabei, dass der Serienanordnung von Akkumulatoren keine Differentiatoren mit nachfolgender Mittelwertbildung folgen sondern nur einige wenige Zwischendatenwörter in jeweils geeignetem zeitlichen Abstand verknüpft werden mittels einfacher Operationen, wie Subtraktion und Addition bzw. Multiplikation mit Faktor 2 oder dergleichen. Somit ist mit geringem Aufwand eine hochgenaue Analog-Digital-Wandlung ausführbar. Außerdem ist auch bei einer Realisierung in Hardware ohne besonderen Aufwand eine Veränderung der Zeitabstände $T_D$ ausführbar.

**Weiterer Vorteil der Erfindung ist, dass keine Rücksetzeinrichtungen bei den Akkumulatoren verwendet werden müssen und somit unverfälschte Ergebnisse erreichbar sind.**

Wichtige Merkmale bei dem Verfahren sind, dass es zur Verarbeitung eines analog bestimmten Messwertsignals vorgesehen ist,

wobei das Messwertsignal einem Delta-Sigma-Modulator zugeführt wird, der ausgangsseitig einen Bitstrom, insbesondere einen Ein-Bit-Datenstrom, zur Verfügung stellt,

insbesondere dessen Mittelwert oder ein gleitender Mittelwert dem Messwertsignal entspricht,

wobei der Bitstrom einem ersten digitalen Filter zugeführt wird, das den Bitstrom in einen Strom von digitalen Zwischenwörtern, also einen Mehrbit-Datenstrom, verwandelt,

wobei das erste digitale Filter eine Anzahl n seriell angeordneter Akkumulatoren, insbesondere Integratoren, aufweist, wobei n ganzzahlig und gleich oder größer als 1 oder 2 ist,

wobei der Bitstrom mit einer Taktfrequenz $f_S$, also mit einer Taktperiode $T_S = 1/f_S$, getaktet ist und somit der Strom von digitalen Zwischenwörtern mit einer Taktfrequenz $f_S$, also Taktperiode $T_S = 1/f_S$, getaktet und somit aktualisiert wird,

wobei das Ausgangssignal des ersten digitalen Filters einem zweiten digitalen Filter zugeführt wird,

wobei das zweite digitale Filter als Ausgangs-Datenwortstrom die Differenz zwischen einem ersten und einem zweiten Ergebnis-Datenwortstrom aufweist,

wobei der erste und zweite Ergebnis-Datenwortstrom über ein erstes und zweites Zeitintervall aus dem Zwischendatenwortstrom bestimmt werden, wobei das erste und das zweite Zeitintervall in einem zeitlichen Abstand T1 angeordnet sind,

wobei der erste Ergebnis-Datenwortstrom aus dem Zweifachen des zum ersten Zeitpunkt gehörigen Zwischendatenworts bestimmt wird, wobei das im zeitlichen Abstand $T_D$ vor dem ersten Zeitpunkt und das im zeitlichen Abstand $T_D$ nach dem ersten Zeitpunkt angeordnete Zwischendatenwort subtrahiert wird,

wobei der zweite Ergebnis-Datenwortstrom aus dem Zweifachen des zum zweiten Zeitpunkt gehörigen Zwischendatenworts bestimmt wird, wobei das im zeitlichen Abstand $T_D$ vor dem zweiten Zeitpunkt und das im zeitlichen Abstand $T_D$ nach dem zweiten Zeitpunkt angeordnete Zwischendatenwort subtrahiert wird.

Von Vorteil ist dabei, dass zur Erreichung eines qualitativ hochwertigen digitalen Signals schon drei Akkumulatoren mit nachgeschaltetem zweiten Differenzial ausreicht.

Bei der Erfindung ist weiter von Vorteil, dass die Berechnungsschritte für die Bestimmung des Ausgangs-Datenwortstrom des zweiten digitalen Filters, also die Differenzbildung zwischen einem ersten und einem zweiten Ergebnis-Datenwortstrom, überlappend ausführbar sind. Somit ist also durch paralleles zeitlich überlappendes Berechnen, also Bilden von solchen Differenzbildungen, die ausgangsseitige Datenrate weiter erhöhbar.

Bei einer vorteilhaften Ausgestaltung ist T1 größer als das oder gleich dem Zweifache(n) von $T_D$. Von Vorteil ist dabei, dass eine Tiefpassfilterung erreichbar ist.

Bei einer vorteilhaften Ausgestaltung ist die Taktperiodendauer $T_D$ ein ganzzahliges Vielfaches von $T_S$. Von Vorteil ist dabei, dass eine Hardware-Realisierung einfach ausführbar ist.

Bei einer vorteilhaften Ausgestaltung besteht das erste digitale Filter aus drei direkt hintereinander angeordneten Integrierern oder Akkumulatoren. Von Vorteil ist dabei, dass eine einfache digitale Tiefpassfilterung herstellbar ist.

Bei einer vorteilhaften Ausgestaltung entspricht der gleitende Mittelwert des Bitstroms dem Messwertsignal. Somit ist der Messwert in hoher Genauigkeit darstellbar, wenn ein großes zeitliches Intervall für den gleitenden Mittelwert zugrunde gelegt wird.

Bei einer vorteilhaften Ausgestaltung wird das im Delta-Sigma-Modulator verwendete Taktsignal an den Takteingang des ersten digitalen Filters angelegt. Von Vorteil ist dabei, dass eine einfache Realisierung ausführbar ist.

Bei einer vorteilhaften Ausgestaltung erzeugt der Trägersignalgenerator ein pulsweitenmoduliertes Signal erzeugt, das der Rotorspule zugeführt wird und im Wesentlichen ein Sinussignal darstellt. Von Vorteil ist dabei, dass die Winkellage der Rotorspule detektierbar ist.

Wichtige Merkmale bei der Resolveranordnung sind, dass die Resolveranordnung zur Erkennung der Winkellage eines Rotors in Bezug auf einen Stator vorgesehen ist,

wobei der Rotor eine Rotorspule trägt und der Stator zwei in Umfangsrichtung gegeneinander um 90° verschobene Statorspulen aufweist,

wobei die Rotorspule mit einem von einem Trägersignalgenerator erzeugten Trägersignal beaufschlagt wird,

wobei jedes an der jeweiligen Statorspule auftretende Signal als jeweiliges Messwertsignal einem jeweiligen Verarbeitungskanal zugeführt wird, innerhalb dessen ein vorgenanntes Verfahren durchgeführt wird.

Von Vorteil ist dabei, dass die Winkellage des Rotors in Bezug auf den Stator in digitaler Form mit hoher Genauigkeit und schneller Taktrate bereit stellbar ist, insbesondere für eine Steuerelektronik oder als Sicherheitsbezogene Zustandsgröße.

Wichtige Merkmale bei dem Verfahren zur Bestimmung eines Ausgangsstromes eines Umrichters sind, dass die dem Ausgangsstrom entsprechenden von einem Sensor erfassten Messsignale einem jeweiligen Verarbeitungskanal zugeführt werden, innerhalb dessen ein oben beschriebenes Verfahren durchgeführt wird. Somit ist vorteiligerweise auch bei Umrichtern eine verbesserte Stromerfassung ausführbar.

Weitere Vorteile ergeben sich aus den Unteransprüchen.

Die Erfindung wird nun anhand von Abbildungen näher erläutert:

Dabei wird die erfindungsgemäße Analog-Digital-Wandlung für eine der

DE 10 2005 005 024 B4 entsprechende Resolverauswertung beschrieben. Sie ist aber auch bei anderen Messwerterfassungen analog anwendbar.

Wie auch bei der Figur 1 der DE 10 2005 005 024 B4 werden zur Erkennung der Winkelposition der Rotorwelle in Bezug auf einen Stator in Umfangsrichtung um gegeneinander um 90° verschoben Statorspulen angeordnet. Die Rotorspule wird mit einem Trägersignal beaufschlagt, das vorzugsweise sinusförmig verläuft und eine Periodendauer $T_C$ aufweist.

An der ersten der Statorspulen wird somit ein Sinussignal und an der zweiten ein Kosinussignal induziert, die einem jeweiligen Verarbeitungskanal zugeführt werden.

Jeder Verarbeitungskanal umfasst hierbei einen Delta-Sigma-Modulator mit einem Ausgang, der einen Bitstrom liefert, also einen Einbit-Datenstrom.

Dieser Einbit-Datenstrom weist als zeitlichen Mittelwert die Information über den Messwert des zugeführten Signals auf.

In der Figur 1 ist für einen jeweiligen Verarbeitungskanal ein Teil eines erfindungsgemäßen, dem Delta-Sigma-Modulator nachgeschalteten Filters gezeigt.

Wie auch bei der DE 10 2005 005 024 B4 werden drei mit einer Taktfrequenz $f_S$, also Taktperiode $T_S$ = 1/ $f_S$, betriebene, vom Filter auch umfasste Integratoren, die auch als Akkumulatoren oder Integrier-Glieder bezeichenbar sind und nicht in der Figur 1 gezeigt sind, seriell hintereinander angeordnet, so dass an dieser seriellen Anordnung ein Zwischendatenwortstrom ausgegeben wird. Im Unterschied zur

DE 10 2005 005 024 B4, bei der der Zwischendatenwortstrom den drei nachfolgend wiederum seriell angeordneten Differentiatoren zugeführt wird, die allerdings mit der viel langsameren Taktfrequenz $f_D$, also Taktperiode $T_D$ = 1/$f_D$, betrieben werden, wird bei der Erfindung ein spezielles Datenverarbeitungsverfahren ausgeführt. Diese spezielle erfindungsgemäße Datenverarbeitung ist in Figur 1 dargestellt.

**Dabei ist wichtig, dass der Zwischendatenwortstrom im Takt der Taktperiode** $T_S$**, also im Sampling-Takt des Delta-Sigma-Modulators, aktualisiert wird.**

Aus diesem Zwischendatenstrom wird ein 2-tes zeitdiskretes Differential, also zeitdiskretes Differential zweiter Ordnung, bestimmt, indem ein erstes Zwischendatenwort zu einem ersten Zeitpunkt zu einem im zeitlichen Abstand 2 x $T_D$ entfernten Zwischendatenwort addiert und von der so gebildeten Summe der doppelte Wert des zeitlich zwischen diesen beiden Zwischendatenwörtern, mittig liegenden Zwischendatenwortes subtrahiert. Somit ist ein erster Ergebniswert gebildet.

Um einen zweiten Ergebniswert zu bilden, wird zu einem vom genannten ersten Zwischendatenwort im zeitlichen Abstand $T_1$ liegenden Zeitintervall dieselbe Operation ausgeführt. Also wird wiederum zu einem dortigen Zwischendatenwort ein im zeitlichen Abstand 2 x $T_D$ entferntes Zwischendatenwort addiert und von der so gebildeten Summe der doppelte Wert des zwischen diesen beiden Zwischendatenwörtern mittig liegenden Zwischendatenwortes subtrahiert, wobei das mittig liegende Zwischendatenwort den zeitlichen Abstand $T_1$ zu dem zur Berechnung des ersten Ergebniswertes herangezogenen, mittig liegenden Zwischendatenwortes aufweist. Somit ist ein zweiter Ergebniswert gebildet.

Die Differenz D der beiden Ergebniswerte wird ausgangsseitig zur Verfügung gestellt und stellt den gefilterten Messwert in digitaler Form dar, wobei eine hohe Genauigkeit erreichbar ist.

Im Gegensatz zur DE 10 2005 005 024 B4 sind keine Differentiatoren und auch kein ausgangsseitiges Dezimierungsfilter OSR2 notwendig, da erfindungsgemäß das ausgangsseitige Ergebnis direkt mittels der Differenz aus erstem und zweitem Ergebnis bestimmt wird.

Besonderer Vorteil der Erfindung ist auch, dass T1 ein beliebiges ganzzahliges Vielfaches von $T_S$ ist, wobei keine weitere Festlegung getroffen werden muss. Selbstverständlich ist dabei vorteiligerweise T1 größer als das Zweifache von $T_D$, also T1 > $T_D$. Da 1 / $T_S$ beispielsweise mehrere MHz beträgt, also beispielsweise mehr als 10 MHz, beträgt, ist T1 in feinen Schritten veränderbar.

Somit ist - insbesondere während des Betriebs - T1 mit hoher zeitlicher Auflösung veränderbar und es sind somit Synchronisierungen auf andere getaktete Signalströme ohne besonderen Aufwand ausführbar. Wenn beispielsweise die erfindungsgemäße Messwertverarbeitung der Signale eines Resolvers einer Steuerelektronik eines Umrichters zugeführt werden, ist es daher in einfacher Weise ermöglicht, eine Synchronisierung auf einen von einem mit dem Umrichter verbundenen Feldbus vorgegebenen Takt auszuführen. Hierzu muss also nur der Wert von T1 verändert werden, was mit der hohen zeitlichen Auflösung von $T_S$ ausführbar ist.

Bei weiteren erfindungsgemäßen Ausführungsbeispielen wird statt dem zweiten zeitdiskreten Differential ein erstes, drittes oder höheres Differential, also zeitdiskretes Differential erster, dritter oder höherer Ordnung eingesetzt, wenn die Anzahl der Integratoren, also Akkumulatoren, entsprechend verändert ist. Wenn also n Integratoren vorgesehen sind, wird zur Bildung des ersten und zweiten Ergebniswertes jeweils ein n-Tupel von regelmäßig voneinander mit Zeitabstand $T_D$ beabstandeten Zwischendatenwörtern $f_k$ verwendet, wobei k von 0 bis n-1 läuft. Dabei wird das Differential gebildet, indem die Summe von

$$(-1)^k \binom{n-1}{k} f_k$$

gebildet wird, wobei k von 0 bis n-1 läuft.

In Figur 2 ist beispielhaft eine Ausführungsform dargestellt, in der das erfindungsgemäße Verfahren zur Erfassung des Ausgangsstroms "i" eines Umrichters, der pulsweitenmoduliert betrieben wird, verwendet wird. Die Messdauer T1 soll sich hierbei beispielsweise über eine halbe PWM-Periodendauer erstrecken. Damit kann T1 mit der hohen zeitlichen Auflösung von $T_S$ entsprechend der gewünschten Messdauer sehr genau eingestellt werden.

In der Figur 2 sind die Zeitpunkte, welche zur Bestimmung der Differentiale zweiter Ordnung verwendet werden jeweils durch ein Dreierpaket von kleinen Strichen dargestellt. Jedes Dreierpaket hat eine zeitliche Länge von 2 x $T_D$. Da $T_D$ aber sehr viel größer als $T_S$ ist, ist eine Darstellung des zeitlichen Abstandes $T_S$ in der Figur 2 nicht mehr möglich.

Des weiteren soll in jeder PWM-Periode eine Messung erfolgen. Somit wird $T_U$ unabhängig von T1 entsprechend der PWM-Periodendauer $T_{PWM}$ festgelegt. Dies kann ebenfalls mit der hohen zeitlichen Auflösung von $T_S$ geschehen. Auch wenn beispielsweise $T_{PWM}$ kein ganzzahliges Vielfaches von $T_S$ ist, bleibt die zeitliche Abweichung hiervon bei der Festlegung von $T_U$ durch Verwendung des erfindungsgemäßen Verfahrens sehr gering.

**Bezugszeichenliste**

$$T_S = 1/f_S \text{ Taktperiode}$$

$$T_D = 1/f_D \text{ Taktperiode}$$

T1 Zeitabstand

**Patentansprüche**

1.  Verfahren zur Verarbeitung eines analog bestimmten Messwertsignals eines Ausgangsstroms eines Umrichters, der pulsweitenmoduliert betrieben wird, wobei das dem Ausgangsstrom entsprechende von einem Sensor erfasste Messwertsignal einem Verarbeitungskanal zugeführt wird und gemäss des Verfahrens verarbeitet wird, wobei das Messwertsignal einem Delta-Sigma-Modulator zugeführt wird, der ausgangsseitig einen Bitstrom, zur Verfügung stellt,
    wobei der Bitstrom einem ersten digitalen Filter zugeführt wird, das den Bitstrom in einen Strom von digitalen Zwischendatenwörtern also einen Mehrbit-Datenstrom, verwandelt und als Ausgangssignal ausgegeben wird,
    wobei das erste digitale Filter eine Anzahl n seriell angeordneter Akkumulatoren, aufweist, wobei n ganzzahlig und gleich oder größer als 1 ist,
    wobei der Bitstrom mit einer Taktfrequenz $f_S$, also mit einer ersten Taktperiode ($T_S$) getaktet ist und somit der Strom von digitalen Zwischenwörtern mit einer ersten Taktfrequenz ($f_S$) getaktet und somit aktualisiert wird, wobei die erste Taktfrequenz dem Kehrwert der ersten Taktperiode ($T_S$) entspricht,
    **dadurch gekennzeichnet, dass**
    das Ausgangssignal des ersten digitalen Filters direkt einem zweiten digitalen Filter zugeführt wird,
    wobei am Ausgang des zweiten digitalen Filters der Signaltakt ($T_U$) ein Vielfaches der ersten Taktperiode ($T_S$) ist,
    ($T_{PWM}$) festgelegt ist.
    wobei ein Ausgangs-Datenwortstrom des zweiten Filters als eine Differenz zwischen einem ersten und einem zweiten Ergebnis-Datenwortstrom ausgegeben wird
    wobei jeweils der erste und zweite Ergebnis-Datenwortstrom über ein jeweiliges erstes und zweites Zeitintervall aus dem Zwischendatenwortstrom bestimmt wird
    wobei das erste und zweite Zeitintervall in einem ersten einem zeitlichen Abstand (T1) angeordnet sind,
    wobei der Zwischendatenwortstrom im Takt der ersten Taktperiode ($T_S$) aktualisiert wird,
    wobei der erste Ergebnis-Datenwortstrom aus dem Zweifachen des zum ersten Zeitpunkt gehörigen Zwischendatenworts bestimmt wird, wobei das in einem zweiten zeitlichen Abstand ($T_D$) vor dem ersten Zeitpunkt und das im zweiten zeitlichen Abstand ($T_D$) nach dem ersten Zeitpunkt angeordnete Zwischendatenwort subtrahiert wird,

wobei der zweite Ergebnis-Datenwortstrom aus dem Zweifachen des zum zweiten Zeitpunkt gehörigen Zwischendatenworts bestimmt wird, wobei das im zweiten zeitlichen Abstand ($T_D$) vor dem zweiten Zeitpunkt und das im zweiten zeitlichen Abstand ($T_D$) nach dem zweiten Zeitpunkt angeordnete Zwischendatenwort subtrahiert wird,

wobei der erste zeitliche Abstand (T1) größer als der zweite zeitliche Abstand ($T_D$) ist,

wobei der erste zeitliche Abstand (T1) ein ganzzahliges Vielfaches der ersten Taktperiode ($T_S$) ist, so dass die erste Taktperiode (T1) mit der zeitlichen Auflösung der ersten Taktperiode ($T_S$) einer halben PWM-Periodendauer gleicht,

wobei der Signaltakt ($T_U$) als Vielfaches der ersten Taktperiode ($T_S$), also mit der zeitlichen Auflösung der ersten Taktperiode ($T_S$), unabhängig von der erste zeitliche Abstand (T1) entsprechend der PWM-Periodendauer

2. Verfahren nach Anspruch 1,
**dadurch gekennzeichnet, dass**
die erste Taktperiode ($T_S$) der Sampling-Takt des Delta-Sigma-Modulators ist, wobei der erste zeitliche Abstand (T1) kein ganzzahliges Vielfaches des zweiten zeitlichen Abstandes ($T_D$) ist.

3. Verfahren nach mindestens einem der vorangegangenen Ansprüche,
**dadurch gekennzeichnet, dass** der erste zeitliche Abstand (T1) größer oder gleich ist als das Zweifache des zweiten zeitlichen Abstandes ($T_D$).

4. Verfahren nach mindestens einem der vorangegangenen Ansprüche,
**dadurch gekennzeichnet, dass** der zweite zeitliche Abstand ($T_D$) ein ganzzahliges Vielfaches des ersten zeitlichen Abstands (T1) ist.

5. Verfahren nach mindestens einem der vorangegangenen Ansprüche,
**dadurch gekennzeichnet, dass**
das erste digitale Filter aus drei direkt hintereinander angeordneten Integrierern oder Akkumulatoren besteht.

6. Verfahren nach mindestens einem der vorangegangenen Ansprüche,
**dadurch gekennzeichnet, dass**
der gleitende Mittelwert des Bitstroms dem Messwertsignal entspricht.

7. Verfahren nach mindestens einem der vorangegangenen Ansprüche,
**dadurch gekennzeichnet, dass**
das im Delta-Sigma-Modulator verwendete Taktsignal an einem Takteingang des ersten digitalen Filters angelegt wird.

8. Verfahren nach mindestens einem der vorangegangenen Ansprüche,
**dadurch gekennzeichnet, dass** das pulsweitenmodulierte Signal von einem Trägersignalgenerator erzeugt wird und das einer Rotorspule zugeführt wird und im Wesentlichen ein Sinussignal darstellt.

9. Resolveranordnung aufweisend mehrere Verarbeitungskanäle, wobei jeder Verarbeitungskanal einen Delta-Sigma Modulator, ein erstes und ein zweites Filter aufweist, und
wobei die Resolveranordnung zur Erkennung der Winkellage eines Rotors in Bezug auf einen Stator vorgesehen ist,
wobei der Rotor eine Rotorspule trägt und der Stator zwei in Umfangsrichtung gegeneinander um 90° verschobene Statorspulen aufweist,
wobei die Rotorspule mit einem von einem Trägersignalgenerator erzeugten Trägersignal beaufschlagt wird,
wobei jedes an der jeweiligen Statorspule auftretende Signal als jeweiliges, analog bestimmtes Messwertsignal einem der einem jeweiligen Verarbeitungskanäle zugeführt wird, wobei jeder Verarbeitungskanal dazu ausgelegt ist, das Verfahren gemäß Ansprüche 1-8 auszuführen.

## Claims

1. Method for processing an analogue-determined measured-value signal of an output current of a converter, which is operated in a pulse-width-modulated manner,
wherein the measured-value signal detected by a sensor and corresponding to the output current is fed to a processing channel and is processed according to the method,
wherein the measured-value signal is fed to a delta-sigma modulator which provides a bit stream on the output side, wherein the bit stream is fed to a first digital filter, which converts the bit stream into a stream of digital intermediate data words, that is to say a multi-bit data stream, and is output as an output signal,
wherein the first digital filter has a number n of accumulators arranged in series, n being a whole number and being equal to or greater than 1,
wherein the bit stream is clocked with a clock frequency $f_S$, that is to say with a first clock period ($T_S$), and thus the stream of digital intermediate words is clocked with a first clock frequency ($f_S$) and is thus updated, the first clock frequency corresponding to the inverse value of the first clock period ($T_S$),

**characterized in that**

the output signal of the first digital filter is fed directly to a second digital filter,

wherein, at the output of the second digital filter, the signal clock ($T_U$) is a multiple of the first clock period ($T_S$), wherein an output data word stream of the second filter is output as a difference between a first and a second result data word stream,

wherein in each case the first and second result data word stream is determined from the intermediate data word stream over a respective first and second time interval,

wherein the first and second time interval are arranged at a first time spacing (T1),

wherein the intermediate data word stream is updated in time with the first clock period ($T_S$),

wherein the first result data word stream is determined from two times the intermediate data word belonging to the first instant, the intermediate data word arranged at a second time spacing ($T_D$) before the first instant and the intermediate data word arranged at the second time spacing ($T_D$) after the first instant being subtracted,

wherein the second result data word stream is determined from two times the intermediate data word belonging to the second instant, the intermediate data word arranged at the second time spacing ($T_D$) before the second instant and the intermediate data word arranged at the second time spacing ($T_D$) after the second instant being subtracted,

wherein the first time spacing (T1) is greater than the second time spacing ($T_D$),

wherein the first time spacing (T1) is a whole-number multiple of the first clock period ($T_S$) so that the first clock period (T1) having the temporal resolution of the first clock period ($T_S$) equals half a PWM period duration,

wherein the signal clock ($T_U$) is defined as a multiple of the first clock period ($T_S$), that is to say having the temporal resolution of the first clock period ($T_S$), independently of the first time spacing (T1) according to the PWM period duration ($T_{PWM}$).

2. Method according to claim 1,
   **characterized in that**
   the first clock period ($T_S$) is the sampling clock of the delta-sigma modulator, wherein the first time spacing (T1) is not a whole-number multiple of the second time spacing ($T_D$).

3. Method according to at least one of the preceding claims, **characterized in that**
   the first time spacing (T1) is greater than or equal to two times the second time spacing ($T_D$).

4. Method according to at least one of the preceding claims, **characterized in that**
the second time spacing ($T_D$) is a whole-number multiple of the first time spacing (T1).

5. Method according to at least one of the preceding claims, **characterized in that**
   the first digital filter consists of three integrators or accumulators arranged directly behind one another.

6. Method according to at least one of the preceding claims, **characterized in that**
   the moving average of the bit stream corresponds to the measured-value signal.

7. Method according to at least one of the preceding claims, **characterized in that**
   the clock signal used in the delta-sigma modulator is applied to a clock input of the first digital filter.

8. Method according to at least one of the preceding claims, **characterized in that**
   the pulse-width-modulated signal is generated by a carrier signal generator and is fed to a rotor coil and is substantially a sine signal.

9. Resolver system having a plurality of processing channels, wherein each processing channel has a delta-sigma modulator, a first filter and a second filter, and
   wherein the resolver system is provided for detecting the angle position of a rotor relative to a stator,
   wherein the rotor carries a rotor coil and the stator has two stator coils which are shifted through 90° relative to one another in the circumferential direction,
   wherein a carrier signal generated by a carrier signal generator is applied to the rotor coil,
   wherein each signal occurring at the respective stator coil is fed as a respective, analogue-determined measured-value signal to one of the respective processing channels, each processing channel being designed to carry out the method according to claims 1 to 8.

## Revendications

1. Procédé de traitement d'un signal de valeur de mesure déterminé analogiquement d'un courant de sortie d'un variateur qui fonctionne en modulation de largeur d'impulsion,
   dans lequel le signal de valeur de mesure correspondant au courant de sortie détecté par un capteur est amené à un canal de traitement et traité selon le procédé,
   dans lequel le signal de valeur de mesure est amené à un modulateur delta-sigma qui fournit un flux de bits du côté sortie,

dans lequel le flux de bits est amené à un premier filtre numérique qui convertit le flux de bits en un flux de mots de données intermédiaires numériques, c'est-à-dire un flux de données multibits, et le délivre en tant que signal de sortie,

dans lequel le premier filtre numérique présente un nombre n d'accumulateurs disposés en série, n étant un nombre entier égal ou supérieur à 1,

dans lequel le flux de bits est cadencé avec une fréquence d'horloge $f_S$, donc avec une première période d'horloge ($T_S$), et ainsi le flux de mots intermédiaires numériques est cadencé avec une première fréquence d'horloge ($f_S$) et ainsi mis à jour, la première fréquence d'horloge correspondant à l'inverse de la première période d'horloge ($T_S$),

**caractérisé en ce que**

le signal de sortie du premier filtre numérique est amené directement à un deuxième filtre numérique, dans lequel, à la sortie du deuxième filtre numérique, l'horloge de signal ($T_U$) est un multiple de la première période d'horloge ($T_S$),

dans lequel un flux de mots de données de sortie du deuxième filtre est délivré en tant que différence entre un premier et un deuxième flux de mots de données résultat,

dans lequel le premier et le deuxième flux de mots de données résultat respectif est déterminé à partir du flux de mots de données intermédiaires sur un premier et un deuxième intervalle de temps respectif, le premier et deuxième intervalle de temps étant disposés à une première distance dans le temps (T1),

dans lequel le flux de mots de données intermédiaires est mis à jour à la cadence de la première période d'horloge ($T_S$),

dans lequel le premier flux de mots de données résultat est déterminé à partir du double du mot de données intermédiaire appartenant au premier instant, le mot de données intermédiaire disposé à une deuxième distance dans le temps ($T_D$) avant le premier instant et le mot de données intermédiaire disposé à la deuxième distance dans le temps ($T_D$) après le premier instant étant soustraits,

dans lequel le deuxième flux de mots de données résultat est déterminé à partir du double du mot de données intermédiaire appartenant au deuxième instant, le mot de données intermédiaire disposé à la deuxième distance dans le temps ($T_D$) avant le deuxième instant et le mot de données intermédiaire disposé à la deuxième distance dans le temps ($T_D$) après le deuxième instant étant soustraits,

dans lequel la première distance dans le temps (T1) est plus grande que la deuxième distance dans le temps ($T_D$),

dans lequel la première distance dans le temps (T1) est un multiple entier de la première période d'horloge ($T_S$), de sorte que la première période d'horloge (T1) avec la résolution temporelle de la première période d'horloge ($T_S$) est égale à une demi-période PWM,

dans lequel l'horloge de signal ($T_U$) est définie comme un multiple de la première période d'horloge ($T_S$), donc avec la résolution temporelle de la première période d'horloge ($T_S$), indépendamment de la première distance dans le temps (T1) correspondant à la période PWM ($T_{PWM}$).

**2.** Procédé selon la revendication 1,
**caractérisé en ce que**
la première période d'horloge ($T_S$) est l'horloge d'échantillonnage du modulateur delta-sigma,
la première distance dans le temps (T1) n'étant pas un multiple entier de la deuxième distance dans le temps ($T_D$).

**3.** Procédé selon au moins l'une des revendications précédentes,
**caractérisé en ce que**
la première distance dans le temps (T1) est supérieure ou égale au double de la deuxième distance dans le temps ($T_D$).

**4.** Procédé selon au moins l'une des revendications précédentes,
**caractérisé en ce que**
la deuxième distance dans le temps ($T_D$) est un multiple entier de la première distance dans le temps (T1).

**5.** Procédé selon au moins l'une des revendications précédentes,
**caractérisé en ce que**
le premier filtre numérique est constitué de trois intégrateurs ou accumulateurs disposés directement l'un derrière l'autre.

**6.** Procédé selon au moins l'une des revendications précédentes,
**caractérisé en ce que**
la valeur moyenne mobile du flux de bits correspond au signal de valeur de mesure.

**7.** Procédé selon au moins l'une des revendications précédentes,
**caractérisé en ce que**
le signal d'horloge utilisé dans le modulateur delta-sigma est appliqué à une entrée d'horloge du premier filtre numérique.

**8.** Procédé selon au moins l'une des revendications précédentes,
**caractérisé en ce que**
le signal modulé en largeur d'impulsion est généré par un générateur de signal porteur et amené à une bobine de rotor, et représente sensiblement un signal sinusoïdal.

**9.** Ensemble résolveur présentant plusieurs canaux de traitement, chaque canal de traitement présentant un modulateur delta-sigma, un premier et un deuxième filtre, l'ensemble résolveur étant prévu pour détecter la position angulaire d'un rotor par rapport à un stator,

dans lequel le rotor porte une bobine de rotor et le stator présente deux bobines de stator décalées de 90° l'une par rapport à l'autre dans la direction circonférentielle,

dans lequel un signal porteur généré par un générateur de signal porteur est appliqué à la bobine de rotor,

dans lequel chaque signal se produisant à la bobine de stator respective est amené en tant que signal de valeur de mesure déterminé analogiquement respectif à un canal de traitement respectif, chaque canal de traitement étant conçu pour mettre en oeuvre le procédé selon les revendications 1 à 8.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005005024 B4
- EP 0320517 B1
- US 5249578 A
- US 5373460 A
- US 6311201 B1